# EUROPEAN PATENT SPECIFICATION

(11) **EP 4 471 436 B1**
(45) Date of publication and mention of the grant of the patent: **21.05.2025**
(21) Application number: 23176129.7
(22) Date of filing: 30.05.2023
(51) Int. Cl.: G01R 15/20

(54) **OPEN LOOP CURRENT TRANSDUCER**
STROMWANDLER MIT OFFENEM REGELKREIS
TRANSDUCTEUR DE COURANT À BOUCLE OUVERTE

(43) Date of publication of application: 04.12.2024
(73) Proprietor: LEM International SA, 1217 Meyrin (CH)
(72) Inventor: MOUCHET, Steve, 74370 FILLIERE (FR)
(74) Representative: reuteler & cie SA

(56) References cited:
- US-A1- 2005 156 587
- US-A1- 2007 046 280
- US-A1- 2007 164 724
- ABB: "Technical Catalog: Current Sensors Voltage Sensors", 2 February 2015 (2015-02-02), XP093100035, Retrieved from the Internet <URL:https://library.e.abb.com/public/8eb5d20c5efc439c923f51804742b3f7/1SBC140152C0207_TechnicalCatalog%20Current-Voltage%20sensors.pdf> [retrieved on 20231109]

## Description

The present invention relates to an open-loop current transducer for mounting around and fixing to a primary conductor bar.

It is known to provide open-loop transducers that have two separate parts that may be assembled around a primary conductor bar, and secured to the primary conductor bar, these transducers being typically configured for a primary conductor bar of a specific size. There are also open-loop current transducers that have two parts pivotally coupled for mounting around a primary conductor. It is known to provide such open loop current transducers without a magnetic core, the transducer has a plurality of discrete magnetic field detectors positioned around the primary conductor bar.

The position of the primary conductor carrying the current to be measured with respect to the magnetic field transducers of the current transducer may impact the measurement accuracy. It is generally desirable to have the magnetic field detectors positioned around the the primary conductor such that the magnetic field is substantially of the same or similar intensity in each of the plurality of magnetic field detectors. This generally means that the centre of the area surrounded by the discrete magnetic field detector is substantially aligned with the centre of cross-sectional area of the primary conductor bar. Even for current transducers having a magnetic core that surrounds the primary conductor, a non-centrally positioned primary conductor with respect to the passage through the magnetic core may cause saturation of the magnetic core on one side that leads to measurement inaccuracies.

ABB: "Technical Catalog: Current Sensors Voltage Sensors", 1 February 2025 (2015-02-01), XP093100035, relates to a ranges of products using various technologies for current and voltage measurements and voltage detection. It discloses an open-loop Hall effect technology and corresponding products to measure current by directly detecting the magnetic field generated by the primary current using a Hall effect element without the use of feedback compensation. Also shown are various brackets for mounting the current sensors, including two-part (clamp-on) types, on rectangular cross-section busbars.

US 2007/46280 A1 (Armando Vilas Boas, [FR]), 1 March 2007 (2007-03-01), relates to an auxiliary element designed for fixing a current sensor relative to an electrical conductor. The auxiliary element features a plate with an internal surface for mounting on a sensor's housing and an external surface with mounting tongues.

US 2007/164724 A1 (Sébastien Nöel [FR]), 19 July 2007 (2007-07-19), relates to a current sensor designed to measure current in a conductor while minimizing sensitivity to parasitic magnetic fields. The sensor utilizes a printed circuit with magnetic-field-sensitive components, such as Hall effect probes, arranged around the conductor. Conductive tracks in a zigzag or braided pattern connect these components, reducing interference from non-homogeneous magnetic fields.

US 2005/156587 A1 (Christopher Paul Yakymyshyn, et al [US]), 21 July 2005 (2005-07-21), relates to a clamp-on current sensor. The sensor employs multiple magnetic field sensors, preferably Hall effect sensors, arranged tangentially around a conductor to approximate Ampere's law. These sensors are housed on printed circuit boards within hinged protective casings.

In view of the foregoing, it is an object of the invention to provide an open-loop current transducer for mounting around a primary conductor bar that may have different dimensions, in particular different thicknesses depending on the intended maximum current to be carried, the transducer being economical to produce yet providing accurate and reliable current measurements.

It is advantageous to provide a current transducer that is easy to install.

It is advantageous to provide a current transducer that is compact.

It is advantageous to provide a current transducer that is economical to produce yet is easy to install around a primary conductor bar and provides good insulation against electrical creepage in high voltage applications.

Objects of this invention have been achieved by providing a system according to claim 1. Dependent claims set forth various advantageous features of embodiments of the invention.

Disclosed herein is an open-loop current transducer configured for mounting around a primary conductor bar having a substantially rectangular cross-section with a width (W) and height (H), the width being greater than the height, the current transducer comprising an insulating support surrounding a central passage through which the primary conductor extends when mounted to the current transducer, the insulating support having at least two parts, a first support part and a second support part mountable together around the primary conductor bar. The current transducer further comprises a plurality of discrete magnetic field sensors arranged within the insulating support around the primary conductor bar. The current transducer further comprises a mounting bracket attached to a branch of the insulating support.

The mounting bracket comprises at least one mounting pillar having a plurality of height adjustment locating holes, and a mounting flange comprising a primary conductor fixing member configured for attachment of the mounting bracket to the primary conductor, the insulating support comprising at least one fixing hole alignable with one of the plurality of height adjustment locating holes, through which a height fixing pin of the current transducer is inserted to locate the height of the mounting bracket relative to the branch of the insulating support comprising the fixing hole such that a height position of the primary conductor bar relative to the insulating support is adjusted.

In an advantageous embodiment, the current transducer is of the coreless type, namely without magnetic core.

In an advantageous embodiment, the current transducer further comprises a circuit board having at least two parts, a first circuit board part lodged in the first support part of the insulating support and a second circuit board part lodged in the second support part of the insulating support, the magnetic field sensors being mounted and connected to the circuit board.

In an advantageous embodiment, the first support part and second support part each comprise a circuit board receiving cavity formed as a recess within the insulating housing on one side of the insulating housing within which the circuit board parts are received.

In an advantageous embodiment, the circuit board receiving cavity is filled with an insulating potting material, or covered by a cover part fixed to the side of the insulating support.

In an advantageous embodiment, the mounting bracket comprises at least two mounting pillars, each comprising a plurality of height adjustment locating holes and the insulating support comprises a corresponding pair of fixing holes alignable with the height adjustment locating holes of each of the mounting pillars, the current transducer comprising at least two height fixing pins one installed through each mounting pillar and corresponding fixing hole.

According to the invention, the mounting bracket comprises a support receiving cradle having a general U-shape cross-sectional profile, having side walls that extend to an upper edge beyond a top side of the branch of the insulating support.

In an advantageous embodiment, the pair of mounting pillars are arranged at ends of the support receiving cradle.

In an advantageous embodiment, the mounting flange is formed at a base of the mounting pillar.

In an advantageous embodiment, wherein the primary conductor fixing member in the mounting flange is in the form of a hole or cut out receiving therethrough a primary conductor fixing screw that is threaded into the primary conductor bar.

In an advantageous embodiment, the height adjustment locating holes comprise at least three height adjustment locating holes positioned at different heights aligned along an axis substantially parallel to a side of the central passage.

In an advantageous embodiment, the mounting bracket is arranged against the branch of the insulating support that extends parallel to the side of the central passage that extends along the width of the central passage.

In an advantageous embodiment, the current transducer comprises a connector interconnected to the magnetic field sensors, for connection to an external connector, the connector presenting a connection interface that is positioned within the support receiving cradle of the mounting bracket, such that the walls of the support receiving cradle overlap and extend upwardly above the connector.

In an advantageous embodiment, the first circuit board part and first insulating support part have a first size, configured for coupling and mounting to a second circuit board part of different sizes.

In an advantageous embodiment, the connector is formed with the first circuit board part and first insulating support part.

Further objects and advantageous features of the invention will be apparent from the claims, from the detailed description, and annexed drawings, in which:
Figure 1a is a perspective view of a current transducer according to an embodiment of the invention mounted on a primary conductor bar;
Figure 1b is a view of the current transducer of figure 1a partially assembled to the primary conductor bar;
Figures 2a to 2c are views, seen in cross-section through the primary conductor bar, showing a current transducer according to embodiments of the invention, whereby figures 2a, 2b and 2c show installations of the current transducer onto primary conductors of different thicknesses (heights);

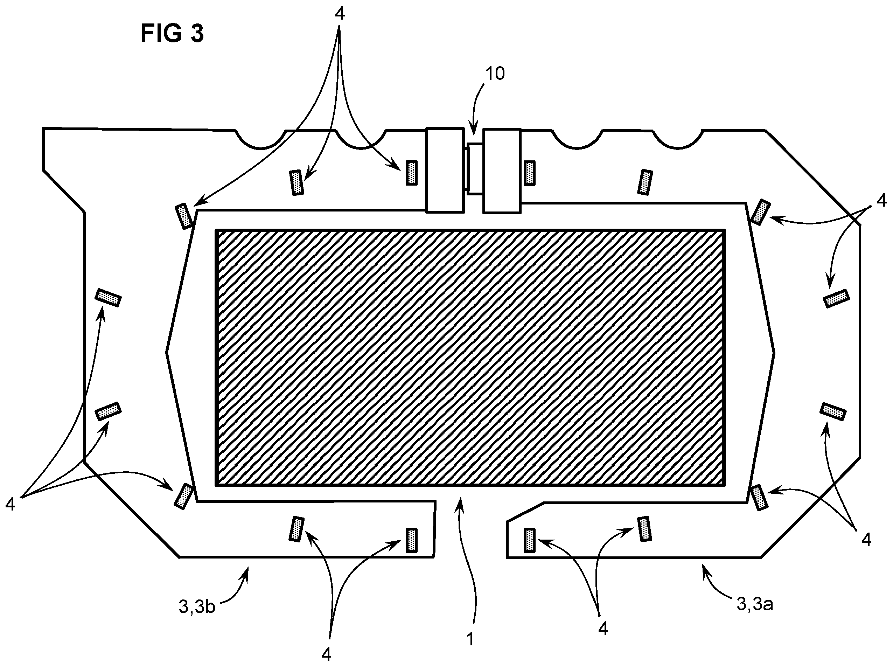

Figure 3 is a schematic view in cross-section through the primary conductor showing a circuit board and magnetic field detectors mounted on the circuit board of a current transducer according to an embodiment of the invention;

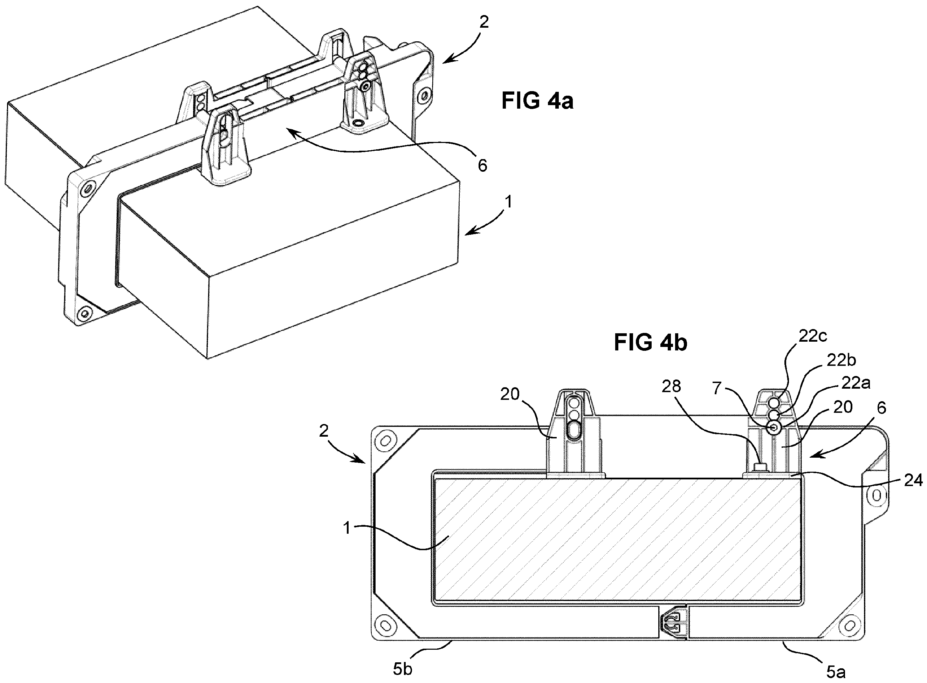

Figure 4a is a perspective view similar to figure 1a of another embodiment of a current transducer for a primary conductor bar with a greater width than in the embodiment of figure 1a;
Figure 4b is a view seen in cross-section through the primary conductor bar of figure 3a showing the current transducer of figure 3a;

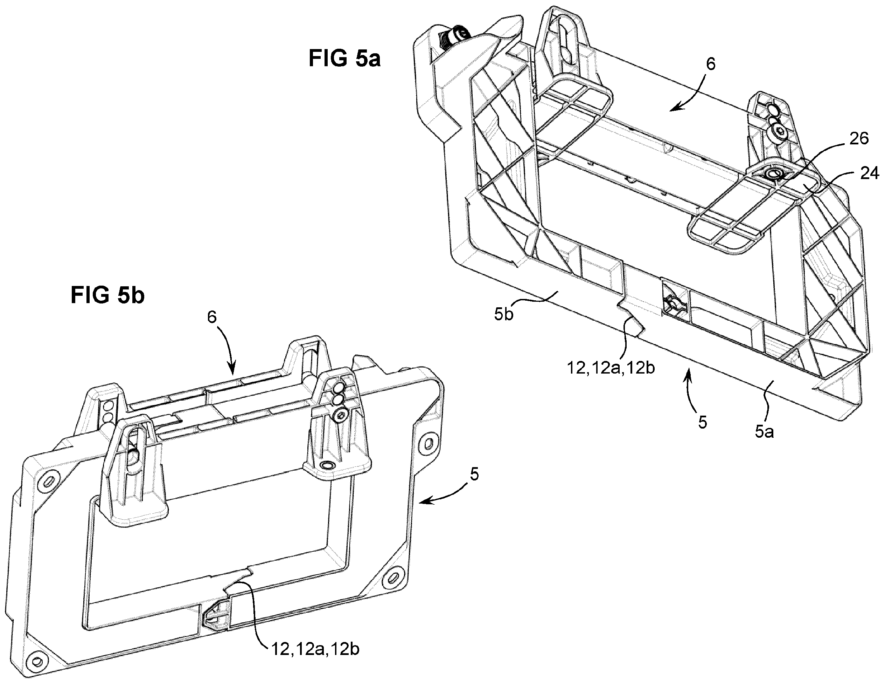

Figures 5a and 5b are perspective views of a current transducer according to embodiments of the invention without the primary conductor bar;

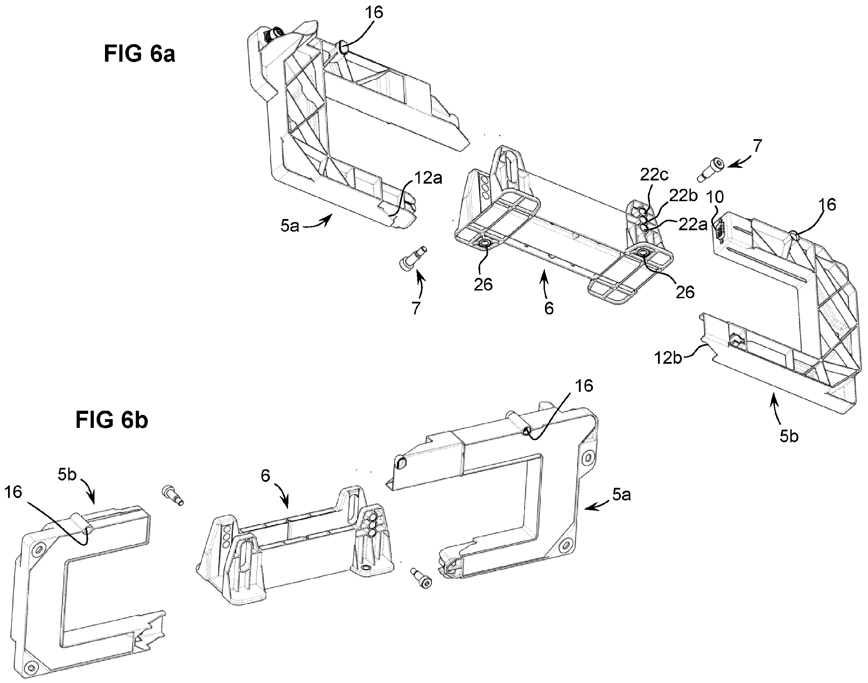

Figures 6a and 6b are perspective exploded views of the current transducer of figures 5a and 5b respectively;

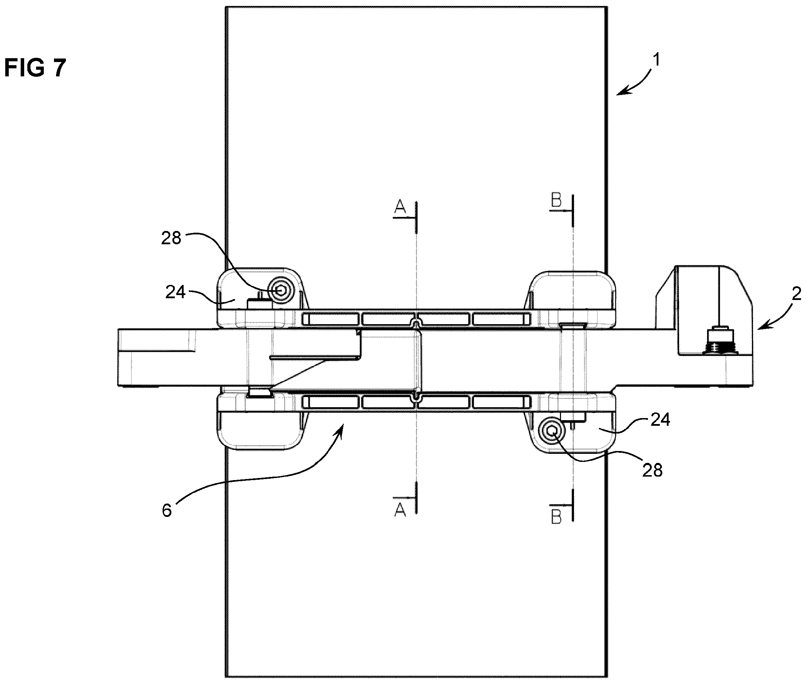

Figure 7 is a top view of the current transducer of figure 1a mounted on primary conductor bar;
Figure 8a is a cross-sectional view through lines A-A of figure 7;
Figure 8b is a cross-sectional view through lines B-B of figure 7.

Referring to the figures, a current transducer 2 according embodiments of the invention is configured for mounting around a primary conductor bar 1 having a substantially rectangular shape with a width ***W*** and a height ***H***.

The current transducer 2 comprises an insulating support 5 and a plurality of magnetic field sensors 4 mounted in the insulating support and distributed around a central passage of the insulating support 5 through which the primary conductor bar 1 is mounted. The current transducer 2 preferably comprises a circuit board 3 on which the plurality of magnetic field sensors 4 are mounted and electrically connected. The circuit board 3 comprises at least two parts, a first circuit board part 3a and a second circuit board part 3b configured to allow the circuit board to be mounted around the primary conductor during the installation of the current transducer 2 around the primary conductor bar 1. The first circuit board part 3a and second circuit board part 3b are provided with interconnections to electrically interconnect the two circuit board parts together. The circuit board 3 further comprises a connector 10 configured for connection to an external complementary connector of an external unit connected to the electrical current transducer for power and signal communication between the external unit and the current transducer 2.

The insulating support 5 comprises at least two parts, a first support part 5a, and a second support part 5b that may be coupled together around the primary conductor bar and mate together at a coupling interface 12. The first circuit board part 3a is mounted to the first support part 5a and the second circuit board part 3b is mounted to the second support part 5b. The support parts 5a, 5b of the insulating support 5 each comprise a circuit board receiving cavity 14, formed as a recess on one side of the insulating support 5, for receiving and lodging the first circuit board part 3a and second circuit board part 3b. An insulating filler material such as a potting resin, or a further cover part covering the cavity 14 may be provided to cover the circuit board 3 within the circuit board receiving cavity 14 of the insulating support 5, to insulatingly separate and protect it from the external environment of the current transducer.

The insulating support 5 comprises one or more fixing holes 16 that serve to receive a height fixing pin 7 therethrough as will be explained in more detail further on.

According to an aspect of the invention the current transducer 2 further comprises a mounting bracket 6 that is positioned against and around a branch of the insulating support 5, between the insulating support 5 and the primary conductor bar 1.

The mounting bracket 6 comprises a support receiving cradle 18 that receives the branch of the insulating support 5 therein. The mounting bracket 6 further comprises mounting pillars 20, preferably positioned at respective ends of the support receiving cradle 18. The support receiving cradle may substantially have a U-shape cross-section, the mounting bracket being configured to be assembled to a long branch side of the current transducer, it being understood that the long branch side extends across the width ***W*** of the primary conductor 1 and is connected to short branch sides that extend along the height ***H*** of the primary conductor, the width ***W*** being greater than the height ***H***.

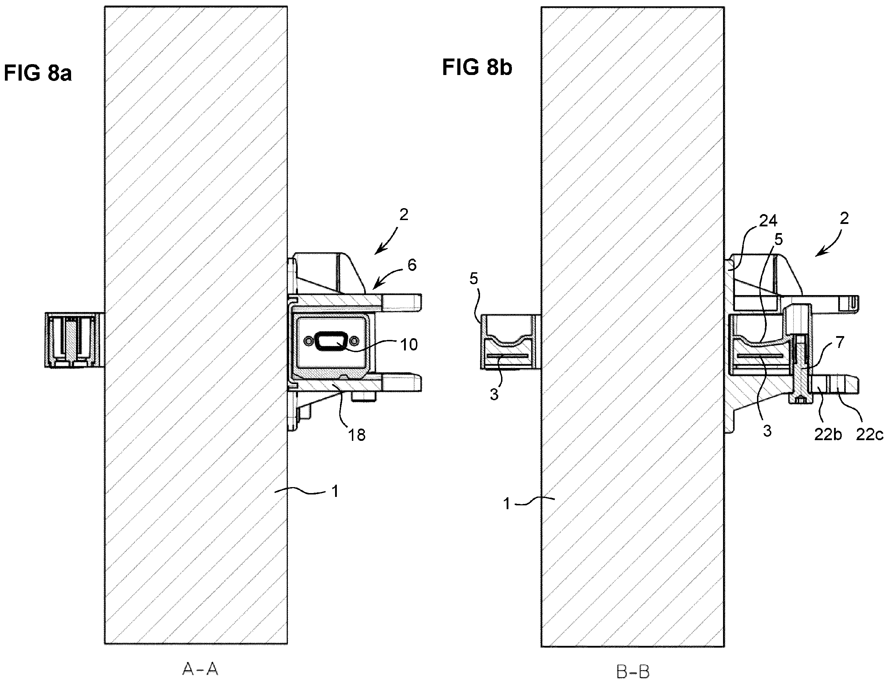

As best seen in figure 8a, the generally U-shaped wall of the support receiving cradle 18 extends around the connector 10, up to an upper edge that is above the connector 10, and longitudinally in the direction of the width that completely overlaps the connector 10 such that a good electrical separation between the connector 10, and the primary conductor 1, is provided. In other words, the electrical creepage distance between the connector 10 and the primary conductor bar 1 is increased by the provision of the U-shaped support receiving cradle 18 that completely overlaps and goes beyond the electrical connector 10.

The mounting pillars 20 of the mounting bracket 6 comprise a plurality of height adjustment locating holes 22, 22a, 22b, 22c for receiving therethrough the height fixing pin 7 that further engages in the fixing holes 16 passing through the insulating support 5. Therefore, the position of the mounting bracket relative to the branch of the insulating support comprising the fixing holes 16 may be adjusted by engaging the height fixing pin 7 through a corresponding one 22a, 22b, 22c of the plurality of height adjustment locating holes in the mounting pillars 20. The mounting pillars 20 of the mounting bracket 6 comprise mounting flanges 24 that are configured to be placed against a surface of the primary conductor 1 that is arranged adjacent the mounting bracket 6. The mounting flange 24 comprises a primary conductor fixing member which may for instance be in the form of a hole or orifice or cut out 26 through which a primary conductor fixing screw is inserted and screwed into a corresponding threaded bore provided in the primary conductor bar 1. The mounting bracket 6 is thus securely fixed to the primary conductor bar 1 during use and the insulating support 5 that houses the circuit board 3 and magnetic field sensors 4 is secured to the mounting bracket 6 by means of the height adjustment locating holes 22 and fixing holes 16 in the insulating support engaged by the height fixing pin 7. The height fixing pin may for instance be in the form of a bolt, or shoulder bolt, or generally comprise a screw thread for screwing in a complementary threaded section of the height adjustment locating hole or to a separate nut engaging the screw thread on the other mounting pillar side outer side. Other means to secure the height fixing pin to the mounting pillar in the assemble position, such as a circlip received in a groove of the pin, or a clamp, or latch protrusion in the mounting pillar fixing hole engaging behind a shoulder on the height fixing pin, or interference fit between the pin and hole, may be provided. The height fixing pin may also be secured by welding or adhesive bonding.

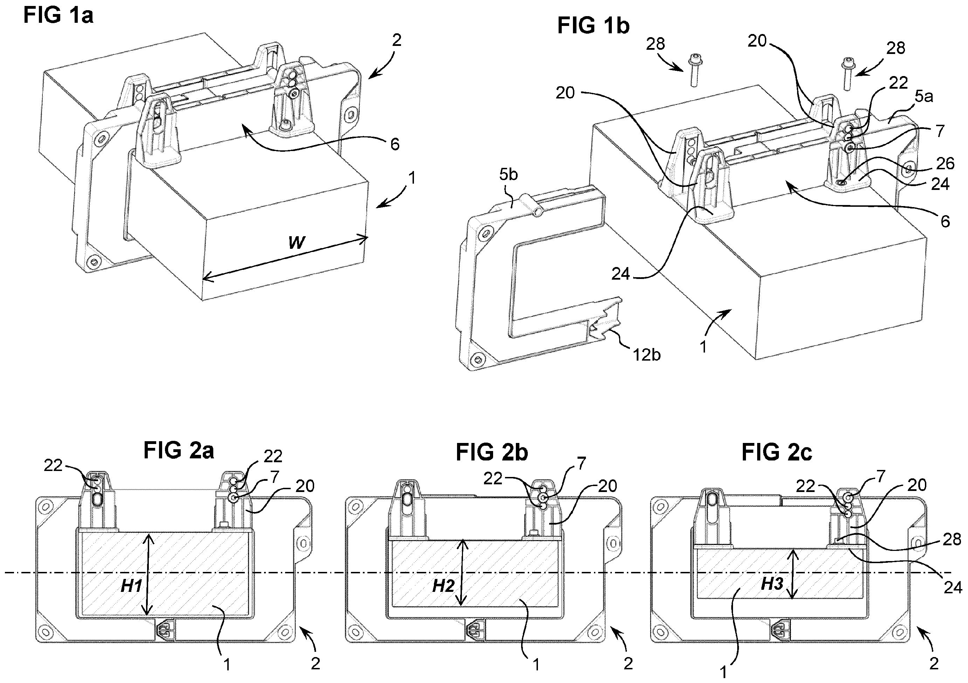

As best seen in figures 2a to 2b, the position of the mounting bracket relative to the branch on one side of the insulating support 5 may be positioned according to the locating hole 22a, 22b, 22c in the mounting bracket that is aligned with the fixing hole 16 in the insulating support, depending on the height ***H1, H2, H3*** of the primary conductor bar. In this example, with three locating holes 22a, 22b, 22c at different heights provided in the mounting pillars 20, three different height positions of the primary conductor bar 1 relative to the branch on the side where the mounting bracket is mounted, may be adjusted. In the example shown in figures 2a to 2b these three positions allow to adjust the position of a primary conductor bar with three different heights such that the center of the primary conductor bar is substantially arranged centrally with respect to a center line of the passage through the insulating support 5 and circuit board 3 such that the primary conductor bar is substantially centrally positioned with respect to the magnetic field sensors 4 that surround the central passage through which the primary conductor bar passes.

For primary conductor bars of different widths, the two circuit board parts 3a, 3b and two insulating support parts 5a, 5b may advantageously comprise an invariable sized first circuit board part 3a and first support part 5a as well as a mounting bracket 6 that remains of constant dimensions irrespective of the width of the primary conductor bar, for coupling to a second circuit board part 3b and second support part 5b that has a width adjusted for the width of the primary conductor. In this fashion, only the second circuit part 3b and second housing part 5b need to be produced with different dimensions, reducing the cost of current transducers for different primary conductor bar widths. In this regard, the connector 10 for connection to an external connector may be provided mounted to first circuit board part 3a such that the second circuit board part 3b and second support part 5b are of a simpler configuration, the simpler configuration leading to lower costs of the variable sized parts.

The current transducer 2 of the illustrated embodiments is of the coreless type, meaning that it does not have a magnetic core surrounding the primary conductor to concentrate the magnetic field, for instance provided with one or two air gaps in which the magnetic field sensor is mounted. The magnetic field detectors 4 may for instance be in the form of Hall detectors that are arranged on the circuit board at substantially equidistant gaps and positioned in a manner with respect to the primary conductor bar that aligns with the magnetic field lines generated by a current flowing through the primary conductor such that the magnetic field intensity captured by each of the magnetic field detectors is similar. Other types of magnetic field detectors *per se* well known in the art could however be used instead of Hall effect detectors, also mounted as discrete components on the circuit board. It may however be noted that instead of a circuit board the magnetic field detectors may be interconnected with wiring or other forms of interconnections and coupled mechanically to the insulating support 5 or another form of insulating support that is not as such a circuit board but that is installed into the insulating housing 5.

In an alternative embodiment (not shown), the current transducer 2 may comprise a two part magnetic core surrounding the primary conductor, a first magnetic core part mounted in the first insulating support and a second magnetic core part mounted in the second housing part. The two core parts, when the housing parts are mounted around the primary conductor bar, form two air gaps between coupling ends of the two parallel branches within which first and second magnetic field detectors are mounted. In this alternative embodiment, there is still an advantage in having the primary conductor substantially centrally positioned in the central passage to avoid a higher concentration and possible saturation in one of the branches of the magnetic core.

### List of references used

**Primary conductor bar 1**
**Current transducer 2**
   **Circuit board 3**
      1^{st} circuit board part 3a
      2^{nd} circuit board part 3b
      Connector 10
   **Magnetic field sensors 4**
   **Insulating support 5**
      **1^{st} support part 5a**
         Coupling interface 12a
      **2^{nd} support part 5b**
         Coupling interface 12b
      Circuit board receiving cavity 14
      Fixing hole 16
   **Mounting bracket 6**
      Support receiving cradle 18
      Mounting pillars 20
         Height adjustment locating holes 22, 22a, 22b, 22c
         Mounting flange 24
            Primary conductor fixing member (hole) 26
   **Height Fixing pin 7**
Primary conductor fixing screw 28

## Claims

1. An open-loop current transducer (2) configured for mounting around a primary conductor bar (1) having a substantially rectangular cross-section with a width (W) and height (H), the width being greater than the height, the current transducer comprising an insulating support (5) surrounding a central passage through which the primary conductor extends when mounted to the current transducer, the insulating support having at least two parts, a first support part (5a) and a second support part (5b) mountable together around the primary conductor bar (1), the current transducer further comprising a plurality of discrete magnetic field sensors arranged within the insulating support (5) around the primary conductor bar, the current transducer further comprising a mounting bracket (6) attached to a branch of the insulating support (5), wherein the mounting bracket (6) comprises at least one mounting pillar (20) having a plurality of height adjustment locating holes (22), and a mounting flange (24) comprising a primary conductor fixing member (26) configured for attachment of the mounting bracket to the primary conductor, the insulating support (5) comprising at least one fixing hole (16) alignable with one of the plurality of height adjustment locating holes, through which a height fixing pin (7) of the current transducer is inserted to locate the height of the mounting bracket (6) relative to the branch of the insulating support comprising the fixing hole such that a height position of the primary conductor bar (1) relative to the insulating support is adjusted, wherein the mounting bracket (6) comprises a support receiving cradle (18) having a general U-shape cross-sectional profile, having side walls that extend to an upper edge beyond a top side of the branch of the insulating support.

2. The current transducer according to the preceding claim wherein the current transducer is of the coreless type, namely without magnetic core.

3. The current transducer according to any preceding claim further comprising a circuit board (3) having at least two parts, a first circuit board part (3a) lodged in the first support part (5a) of the insulating support (5) and a second circuit board part (3b) lodged in the second support part (5b) of the insulating support (5), the magnetic field sensors (4) being mounted and connected to the circuit board (3).

4. The current transducer according to the preceding claim wherein the first support part (5a) and second support part (5b) each comprise a circuit board receiving cavity (14) formed as a recess within the insulating housing on one side of the insulating housing within which the circuit board parts are received.

5. The current transducer according to the preceding claim wherein the circuit board receiving cavity (14) is filled with an insulating potting material, or covered by a cover part fixed to the side of the insulating support (5).

6. The current transducer according to any preceding claim wherein the mounting bracket (6) comprises at least two mounting pillars (20), each comprising a plurality of height adjustment locating holes (22) and the insulating support (5) comprises a corresponding pair of fixing holes (16) alignable with the height adjustment locating holes of each of the mounting pillars (20), the current transducer comprising at least two height fixing pins (7) one installed through each mounting pillar (20) and corresponding fixing hole (16).

7. The current transducer according to any preceding claim wherein the pair of mounting pillars (20) are arranged at ends of the support receiving cradle (18).

8. The current transducer according to any preceding claim wherein the mounting flange (24) is formed at a base of the mounting pillar (20).

9. The current transducer according to any preceding claim wherein the primary conductor fixing member in the mounting flange (24) is in the form of a hole or cut out (26) receiving therethrough a primary conductor fixing screw (28) that is threaded into the primary conductor bar.

10. The current transducer according to any preceding claim wherein the height adjustment locating holes comprise at least three height adjustment locating holes positioned at different heights aligned along an axis substantially parallel to a side of the central passage.

11. The current transducer according to any preceding claim wherein the mounting bracket is arranged against the branch of the insulating support that extends parallel to the side of the central passage that extends along the width of the central passage.

12. The current transducer according to any preceding claim wherein the current transducer comprises a connector (10) interconnected to the magnetic field sensors (4), for connection to an external connector, the connector (10) presenting a connection interface that is positioned within the support receiving cradle (18) of the mounting bracket (6), such that the walls of the support receiving cradle overlap and extend upwardly above the connector (10).

13. The current transducer according to any preceding claim wherein the first circuit board part (3a) and first insulating support part (5a) have a first size, configured for coupling and mounting to a second circuit board part (3b) of different sizes.

14. The current transducer according to the preceding claim wherein the connector (10) is formed with the first circuit board part (3a) and first insulating support part (5a).

## Patentansprüche

1. Stromwandler (2) mit offenem Regelkreis, der zum Montieren um eine Primärleiterschiene (1) ausgestaltet ist, die einen im Wesentlichen rechtwinkligen Querschnitt mit einer Breite (W) und Höhe (H) aufweist, wobei die Breite größer ist als die Höhe, wobei der Stromwandler eine isolierende Stütze (5) umfasst, die einen mittleren Durchgang umgibt, durch den der Primärleiter sich erstreckt, wenn er an dem Stromwandler montiert ist, wobei die isolierende Stütze mindestens zwei Teile aufweist, einen ersten Stützenteil (5a) und einen zweiten Stützenteil (5b), die zusammen um die Primärleiterschiene (1) montierbar sind, wobei der Stromwandler ferner eine Vielzahl von diskreten Magnetfeldsensoren umfasst, die innerhalb der isolierenden Stütze (5) um die Primärleiterschiene eingerichtet sind, wobei der Stromwandler ferner eine Montagehalterung (6) umfasst, die an einem Schenkel der isolierenden Stütze (5) angebracht ist, wobei die Montagehalterung (6) mindestens eine Montagesäule (20), die eine Vielzahl von Höhenanpassungsfixierungslöchern (22) aufweist, und einen Montageflansch (24) umfasst, der ein Primärleiter-Befestigungselement (26) umfasst, das zur Anbringung der Montagehalterung an dem Primärleiter ausgestaltet ist, wobei die isolierende Stütze (5) mindestens ein Befestigungsloch (16) umfasst, das mit einem der Vielzahl von Höhenanpassungsfixierungslöchern ausrichtbar ist, durch die ein Höhenbefestigungsstift (7) des Stromwandlers eingesetzt wird, um die Höhe der Montagehalterung (6) in Bezug auf den Schenkel der isolierenden Stütze zu fixieren, die das Befestigungsloch umfasst, derart dass eine Höhenposition der Primärleiterschiene (1) in Bezug auf die isolierende Stütze angepasst wird, wobei die Montagehalterung (6) ein Stützenaufnahmegestell (18) umfasst, das ein allgemein U-förmiges Querschnittsprofil aufweist und Seitenwände aufweist, die sich zu einer oberen Kante über eine obere Seite des Schenkels der isolierenden Stütze hinaus erstreckt.

2. Stromwandler nach dem vorhergehenden Anspruch, wobei der Stromwandler vom kernlosen Typ, das heißt ohne Magnetkern, ist.

3. Stromwandler nach einem der vorhergehenden Ansprüche, der ferner eine Leiterplatte (3) umfasst, die mindestens zwei Teile aufweist, einen ersten Leiterplattenteil (3a), der in dem ersten Stützenteil (5a) der isolierenden Stütze (5) untergebracht ist, und einen zweiten Leiterplattenteil (3b), der in dem zweiten Stützenteil (5b) der isolierenden Stütze (5) untergebracht ist, wobei die Magnetfeldsensoren (4) an der Leiterplatte (3) montiert und damit verbunden sind.

4. Stromwandler nach dem vorhergehenden Anspruch, wobei der erste Stützenteil (5a) und der zweite Stützenteil (5b) jeweils einen Leiterplatten-Aufnahmehohlraum (14) umfassen, der als eine Vertiefung innerhalb des isolierenden Gehäuses auf einer Seite des isolierenden Gehäuses gebildet ist und in dem die Leiterplattenteile aufgenommen sind.

5. Stromwandler nach dem vorhergehenden Anspruch, wobei der Leiterplatten-Aufnahmehohlraum (14) mit einem isolierenden Vergussmaterial gefüllt ist oder durch einen Abdeckungsteil bedeckt ist, der an der Seite der isolierenden Stütze (5) befestigt ist.

6. Stromwandler nach einem der vorhergehenden Ansprüche, wobei die Montagehalterung (6) mindestens zwei Montagesäulen (20) umfasst, die jeweils eine Vielzahl von Höhenanpassungsfixierungslöchern (22) umfassen, und die isolierende Stütze (5) ein entsprechendes Paar Befestigungslöcher (16) umfasst, die mit den Höhenanpassungsfixierungslöchern von jeder der Montagesäulen (20) ausrichtbar sind, wobei der Stromwandler mindestens zwei Höhenbefestigungsstifte (7) umfasst, von denen einer durch jede Montagesäule (20) und das entsprechende Befestigungsloch (16) eingerichtet ist.

7. Stromwandler nach einem der vorhergehenden Ansprüche, wobei das Paar Montagesäulen (20) an Enden des Stützenaufnahmegestells (18) eingerichtet sind.

8. Stromwandler nach einem der vorhergehenden Ansprüche, wobei der Montageflansch (24) an einer Basis der Montagesäule (20) gebildet ist.

9. Stromwandler nach einem der vorhergehenden Ansprüche, wobei das Primärleiter-Befestigungselement in dem Montageflansch (24) in der Form eines Lochs oder Ausschnitts (26) vorliegt, das bzw. der dort hindurch eine Primärleiter-Befestigungsschraube (28) aufnimmt, die in die Primärleiterschiene eingeschraubt ist.

10. Stromwandler nach einem der vorhergehenden Ansprüche, wobei die Höhenanpassungsfixierungslöcher mindestens drei Höhenanpassungsfixierungslöcher umfassen, die auf unterschiedlichen Höhen positioniert und entlang einer Achse ausgerichtet sind, die im Wesentlichen parallel zu einer Seite des mittleren Durchgangs ist.

11. Stromwandler nach einem der vorhergehenden Ansprüche, wobei die Montagehalterung gegen den Schenkel der isolierenden Stütze eingerichtet ist, der sich parallel zu der Seite des mittleren Durchgangs erstreckt, die sich entlang der Breite des mittleren Durchgangs erstreckt.

12. Stromwandler nach einem der vorhergehenden Ansprüche, wobei der Stromwandler einen mit den Magnetfeldsensoren (4) verbundenen Verbinder (10) zur Verbindung mit einem externen Leiter umfasst, wobei der Verbinder (10) eine Verbindungsschnittstelle aufweist, die derart innerhalb des Stützenaufnahmegestells (18) der Montagehalterung (6) positioniert ist, dass die Wände des Stützenaufnahmegestells sich überlappen und sich nach oben über den Verbinder (10) erstrecken.

13. Stromwandler nach einem der vorhergehenden Ansprüche, wobei der erste Leiterplattenteil (3a) und der erste isolierende Stützenteil (5a) eine erste Größe aufweisen, die zum Koppeln und Montieren an einem zweiten Leiterplattenteil (3b) mit unterschiedlichen Größen ausgestaltet ist.

14. Stromwandler nach dem vorhergehenden Anspruch, wobei der Verbinder (10) mit dem ersten Leiterplattenteil (3a) und dem ersten isolierenden Stützenteil (5a) gebildet ist.

## Revendications

1. Transducteur de courant à boucle ouverte (2) configuré pour être monté autour d'une barre de conducteur primaire (1) ayant une section transversale sensiblement rectangulaire avec une largeur (W) et une hauteur (H), la largeur étant supérieure à la hauteur, le transducteur de courant comprenant un support isolant (5) entourant un passage central à travers lequel le conducteur primaire s'étend lorsqu'il est monté sur le transducteur de courant, le support isolant ayant au moins deux parties, une première partie de support (5a) et une seconde partie de support (5b) pouvant être montées ensemble autour de la barre de conducteur primaire (1), le transducteur de courant comprenant en outre une pluralité de capteurs de champ magnétique discrets agencés dans le support isolant (5) autour de la barre de conducteur primaire, le transducteur de courant comprenant en outre une ferrure de montage (6) fixée à une branche du support isolant (5), dans lequel la ferrure de montage (6) comprend au moins un pilier de montage (20) ayant une pluralité de trous de positionnement de réglage de hauteur (22), et une bride de montage (24) comprenant un élément de fixation de conducteur primaire (26) configuré pour la fixation de la ferrure de montage au conducteur primaire, le support isolant (5) comprenant au moins un trou de fixation (16) pouvant s'aligner avec l'un de la pluralité de trous de positionnement de réglage de hauteur, à travers lequel une broche de fixation de hauteur (7) du transducteur de courant est insérée pour positionner la hauteur de la ferrure de montage (6) par rapport à la branche du support isolant comprenant le trou de fixation de sorte qu'une position de hauteur de la barre de conducteur primaire (1) par rapport au support isolant est réglée, dans lequel la ferrure de montage (6) comprend un berceau de réception de support (18) ayant un profil transversal généralement en forme de U, ayant des parois latérales qui s'étendent vers un bord supérieur au-delà d'un côté supérieur de la branche du support isolant.

2. Transducteur de courant selon la revendication précédente, dans lequel le transducteur de courant est du type sans noyau, c'est-à-dire sans noyau magnétique.

3. Transducteur de courant selon l'une quelconque des revendications précédentes, comprenant en outre une carte de circuit imprimé (3) ayant au moins deux parties, une première partie de carte de circuit imprimé (3a) logée dans la première partie de support (5a) du support isolant (5) et une seconde partie de carte de circuit imprimé (3b) logée dans la seconde partie de support (5b) du support isolant (5), les capteurs de champ magnétique (4) étant montés et raccordés à la carte de circuit imprimé (3).

4. Transducteur de courant selon la revendication précédente, dans lequel la première partie de support (5a) et la seconde partie de support (5b) comprennent chacune une cavité de réception de carte de circuit imprimé (14) formée comme un évidement dans le boîtier isolant sur un côté du boîtier isolant à l'intérieur duquel les parties de carte de circuit imprimé sont reçues.

5. Transducteur de courant selon la revendication précédente, dans lequel la cavité de réception de carte de circuit imprimé (14) est remplie avec un matériau d'enrobage isolant, ou recouverte par une partie de recouvrement fixée sur le côté du support isolant (5).

6. Transducteur de courant selon l'une quelconque des revendications précédentes, dans lequel la ferrure de montage (6) comprend au moins deux piliers de montage (20), chacun comprenant une pluralité de trous de positionnement de réglage de hauteur (22) et le support isolant (5) comprend une paire correspondante de trous de fixation (16) pouvant s'aligner avec les trous de positionnement de réglage de hauteur de chacun des piliers de montage (20), le transducteur de courant comprenant au moins deux broches de fixation de hauteur (7), une installée à travers chaque pilier de montage (20) et le trou de fixation (16) correspondant.

7. Transducteur de courant selon l'une quelconque des revendications précédentes, dans lequel la paire de piliers de montage (20) est agencée aux extrémités du berceau de réception de support (18).

8. Transducteur de courant selon l'une quelconque des revendications précédentes, dans lequel la bride de montage (24) est formée à une base du pilier de montage (20).

9. Transducteur de courant selon l'une quelconque des revendications précédentes, dans lequel l'élément de fixation de conducteur primaire dans la bride de montage (24) se présente sous la forme d'un trou ou d'une découpe (26) recevant à travers ce dernier (cette dernière) une vis de fixation de conducteur primaire (28) qui est vissée dans la barre de conducteur primaire.

10. Transducteur de courant selon l'une quelconque des revendications précédentes, dans lequel les trous de positionnement de réglage de hauteur comprennent au moins trois trous de positionnement de réglage de hauteur positionnés à différentes hauteurs alignées le long d'un axe sensiblement parallèle à un côté du passage central.

11. Transducteur de courant selon l'une quelconque des revendications précédentes, dans lequel la ferrure de montage est agencée contre la branche du support isolant qui s'étend parallèlement au côté du passage central qui s'étend le long de la largeur du passage central.

12. Transducteur de courant selon l'une quelconque des revendications précédentes, dans lequel le transducteur de courant comprend un connecteur (10) interconnecté aux capteurs de champ magnétique (4), pour le raccordement à un connecteur externe, le connecteur (10) présentant une interface de raccordement qui est positionnée dans le berceau de réception de support (18) de la ferrure de montage (6), de sorte que les parois du berceau de réception de support chevauchent et s'étendent vers le haut au-dessus du connecteur (10).

13. Transducteur de courant selon l'une quelconque des revendications précédentes, dans lequel la première partie de carte de circuit imprimé (3a) et la première partie de support isolant (5a) ont une première taille, configurées pour se coupler et se monter sur une seconde partie de carte de circuit imprimé (3b) de différentes tailles.

14. Transducteur de courant selon l'une quelconque des revendications précédentes, dans lequel le connecteur (10) est formé avec la première partie de carte de circuit imprimé (3a) et la première partie de support isolant (5a).
